# EUROPEAN PATENT APPLICATION

(11) **EP 4 369 426 A1**
(43) Date of publication of application: **15.05.2024**
(21) Application number: 22837594.5
(22) Date of filing: 30.06.2022
(51) Int. Cl.: H01L 33/10, H01L 33/08, H01L 33/32, H01L 33/38

(54) **SEMICONDUCTOR LIGHT-EMITTING ELEMENT, VEHICLE LAMP, AND METHOD FOR MANUFACTURING SEMICONDUCTOR LIGHT-EMITTING ELEMENT**

(30) Priority: 08.07.2021 JP 2021113881
(71) Applicant: KOITO MANUFACTURING CO., LTD., Minato-ku, Tokyo, 108-8711 (JP)
(72) Inventor: KANAOKA, Hiroaki, Shizuoka-shi, Shizuoka 424-8764 (JP); NOMURA, Akihiro, Shizuoka-shi, Shizuoka 424-8764 (JP)
(74) Representative: Cabinet Beau de Loménie
(86) International application number: PCT/JP2022/026283
(87) International publication number: WO 2023/282178

(57) **Abstract**

A semiconductor light-emitting element includes: a growth substrate (11); a plurality of columnar semiconductor layers (13, 14) formed on the growth substrate (11); and an embedded layer (16) with which the plurality of columnar semiconductor layers (13, 14) are covered, in which each of the plurality of columnar semiconductor layers (13, 14) includes an n-type nanowire layer (13) at a center of each of the plurality of columnar semiconductor layers (13, 14) and an active layer (14) on an outer periphery side of the n-type nanowire layer (13), and a gap (17) is provided between the embedded layer (16) between the columnar semiconductor layer (13, 14) and the columnar semiconductor layer (13, 14), and the growth substrate (11).

## Description

### TECHNICAL FIELD

The present disclosure relates to a semiconductor light-emitting element, a vehicle lamp, and a method for manufacturing a semiconductor light-emitting element, and more particularly, to a semiconductor light-emitting element having a structure in which a plurality of columnar semiconductor layers are embedded in an embedded layer, a vehicle lamp, and a method for manufacturing a semiconductor light-emitting element.

### BACKGROUND ART

The semiconductor light-emitting element emits light by recombination of positive holes and electrons in an active layer. In the related art, a flat sheet-shaped well layer is used as the active layer. In recent years, the active layer having a three-dimensional structure such as a columnar structure has been studied. Such a semiconductor light-emitting element has, as an example, a configuration in which the active layer is formed around an n-type columnar semiconductor layer, a p-type semiconductor layer is formed around the active layer, and the periphery of the p-type semiconductor layer is filled with an embedded layer.

On the other hand, in the semiconductor light-emitting element, the improvement in an extraction efficiency of light emitted from the active layer is required as a common problem. Further, an extraction direction of the light emitted in the semiconductor light-emitting element includes an upper surface, a side surface, a lower surface, and the like, and light is often extracted from the upper surface with the intention of face-up mounting. That is, the improvement in an extraction efficiency of the light from the upper surface of the semiconductor light-emitting element may be required.

In the semiconductor light-emitting element using columnar semiconductor layers, for example, Patent Literature 1 is known as a technique in the related art for improving the extraction efficiency of light from the upper surface. The semiconductor light-emitting element according to Patent Literature 1 includes a plurality of columnar semiconductors each having a hexagonal shape and a light extraction surface having a plurality of convex portions, and a pitch interval of the columnar semiconductors is different from a pitch interval of the convex portions. In Patent Literature 1, by providing such a configuration, the light extraction efficiency of the semiconductor light-emitting element having the active layer with a three-dimensional microstructure can be improved.

### CITATION LIST

### PATENT LITERATURE

Patent Literature 1: JP2020-077817A

### SUMMARY OF INVENTION

### TECHNICAL PROBLEM

Therefore, the columnar semiconductor layer as described above is also referred to as a nanowire, and a semiconductor light-emitting element using the nanowires (for example, a light emitting diode (LED)) has attracted attention because the semiconductor light-emitting element can prevent a power efficiency in a high current region from being decreased. The semiconductor light-emitting element using the nanowires has, for example, a configuration in which an active layer and a p-type GaN layer are grown around the nanowire formed of n-type GaN and having a hexagonal columnar shape.

That is, a semiconductor light-emitting element including a flat active layer in the related art has a so-called two-dimensional structure, whereas the semiconductor light-emitting element using the nanowires has a three-dimensional structure. Therefore, the semiconductor light-emitting element using the nanowires is characterized in that an amount of light emitted in a side surface direction is large. In this case, the light emitted in the side surface direction is affected by light scattering, light absorption, and the like due to the surrounding nanowires, and the light extraction efficiency is limited. On the other hand, in a case in which the light is desired to be extracted mainly from the upper surface of the semiconductor light-emitting element, a technique (optical path conversion technique) for converting the light emitted in the side surface direction into an upper surface direction is required.

For example, it is conceivable that a reflecting mirror is provided, as the optical path conversion technique, outside the semiconductor light-emitting element, for example, in a package that houses the semiconductor light-emitting element. However, such a method has a problem in that the package that houses the semiconductor light-emitting element becomes complicated. In addition, in a process of manufacturing a semiconductor light-emitting element, a method in which an optical path conversion technique including a mirror surface is formed inside the semiconductor light-emitting element can be considered. However, such a method generally has a problem in that the process of manufacturing a semiconductor light-emitting element becomes complicated. In this respect, Patent Literature 1 does not refer to the optical path conversion technique for converting the light emitted in the side surface direction into the upper surface direction.

Therefore, the present disclosure has been made in view of the above-described problems in the related art, and an object thereof is to provide a semiconductor light-emitting element, a vehicle lamp, and a method for manufacturing a semiconductor light-emitting element that can increase an amount of light emitted from an upper surface with a simple configuration.

### SOLUTION TO PROBLEM

In order to solve the above-described problems, a semiconductor light-emitting element according to the present disclosure includes: a growth substrate; a plurality of columnar semiconductor layers on the growth substrate; and an embedded layer with which the plurality of columnar semiconductor layers are covered, in which each of the plurality of columnar semiconductor layers includes: an n-type nanowire layer at a center of each of the columnar semiconductor layers; and an active layer on an outer periphery side of the n-type nanowire layer, and the embedded layer defines a gap above the growth substrate between the columnar semiconductor layer and the columnar semiconductor layer.

In such a semiconductor light-emitting element according to the present disclosure, the gap is defined inside the embedded layer between the columnar semiconductor layers, and thus light generated from the active layer and traveling in a lateral direction is reflected or scattered by the gap, such that an amount of light emitted from an upper surface can be increased.

In one aspect of the present disclosure, the growth substrate is a GaN substrate, and the embedded layer is a GaN layer.

In one aspect of the present disclosure, the embedded layer is an ITO film.

In one aspect of the present disclosure, each of the plurality of columnar semiconductors further includes a p-type semiconductor layer on an outer periphery side of the active layer.

In one aspect of the present disclosure, the p-type semiconductor layer includes a contact layer at least on an upper surface thereof, the embedded layer is an insulator layer transparent to light generated from the active layer, the semiconductor light-emitting element further includes a transparent electrode disposed on the insulator layer, and the contact layer protrudes from the insulator layer and is in contact with the transparent electrode.

In one aspect of the present disclosure, an aspect ratio defined by a height of the columnar semiconductor layers and an interval between the columnar semiconductor layers is 0.5 or more, and more preferably 3 to 5.

In order to solve the above-described problems, a vehicle lamp according to the present disclosure uses the above-described semiconductor light-emitting element.

In order to solve the above-described problems, a method for manufacturing a semiconductor light-emitting element according to the present disclosure includes: a masking step of forming a mask layer on a growth substrate, the mask layer having a plurality of openings; a growing step of forming a plurality of columnar semiconductor layers in the respective plurality of openings using selective growth; and an embedding step of growing an embedded layer on the growth substrate so as to cover the plurality of columnar semiconductor layers, in which the growing step includes: a step of forming an n-type nanowire layer; a step of forming an active layer outside the n-type nanowire layer; and a step of forming a p-type semiconductor layer outside the active layer, and the embedding step includes a step of forming a gap on the mask layer between the columnar semiconductor layers inside the embedded layer.

In one aspect of the present disclosure, an aspect ratio defined by a height of the columnar semiconductor layers and an interval between the columnar semiconductor layers is set to 0.5 or more, and more preferably 3 to 5.

### ADVANTAGEOUS EFFECTS OF INVENTION

According to the present disclosure, it is possible to provide the semiconductor light-emitting element, the vehicle lamp, and the method for manufacturing a semiconductor light-emitting element that can increase the amount of light emitted from the upper surface with a simple configuration.

### BRIEF DESCRIPTION OF DRAWINGS

[FIG. 1A] FIG. 1A is a cross-sectional view of a semiconductor light-emitting element 10 according to a first embodiment.
[FIG. 1B] FIG. 1B is a diagram illustrating an operation of the semiconductor light-emitting element 10.
[FIG. 2A] FIG. 2A is a cross-sectional view illustrating a mask forming step of a method for manufacturing the semiconductor light-emitting element 10.
[FIG. 2B] FIG. 2B is a cross-sectional view illustrating a nanowire growing step of the method for manufacturing the semiconductor light-emitting element 10.
[FIG. 2C] FIG. 2C is a cross-sectional view illustrating a growing step of an active layer and a p-type semiconductor layer in the method for manufacturing the semiconductor light-emitting element 10.
[FIG. 2D] FIG. 2D is a cross-sectional view illustrating a void forming step of the method for manufacturing the semiconductor light-emitting element 10.
[FIG. 2E] FIG. 2E is a diagram illustrating a groove etching step and an activation step of the method for manufacturing the semiconductor light-emitting element 10.
[FIG. 2F] FIG. 2F is a diagram illustrating an electrode forming step of the method for manufacturing the semiconductor light-emitting element 10.
[FIG. 3A] FIG. 3A is a diagram illustrating formation positions of voids in the semiconductor light-emitting element 10.
[FIG. 3B] FIG. 3B is a diagram illustrating the voids connected by connection portions of the semiconductor light-emitting element 10.
[FIG. 4] FIG. 4 is a diagram illustrating an SEM photograph of the voids formed in the semiconductor light-emitting element 10.
[FIG. 5A] FIG. 5A is a diagram illustrating a growth substrate being tilted to cause an ITO target to fly from a predetermined direction in a method for manufacturing a semiconductor light-emitting element according to a second embodiment.
[FIG. 5B] FIG. 5B is a diagram illustrating the ITO target flying from a direction different from the predetermined direction in the method for manufacturing a semiconductor light-emitting element according to the second embodiment.
[FIG. 5C] FIG. 5C is a diagram illustrating the ITO target flying with the growth substrate kept horizontal in the method for manufacturing a semiconductor light-emitting element according to the second embodiment.
[FIG. 6] FIG. 6 is a cross-sectional view of a semiconductor light-emitting element 50 according to a third embodiment.
[FIG. 7] FIG. 7 is a cross-sectional view of a semiconductor light-emitting element 60 according to a fourth embodiment.

### DESCRIPTION OF EMBODIMENTS

Hereinafter, embodiments of the present disclosure will be described in detail with reference to the drawings. The same or equivalent components, members, and processes illustrated in the drawings are denoted by the same reference numerals, and redundant description thereof will be omitted as appropriate. In the embodiments to be described below, the present embodiment is intended to be applied to a face-up type semiconductor light-emitting element, and a description will be given of the semiconductor light-emitting element in which an amount of light emitted from an upper surface is increased. Such a semiconductor light-emitting element is used for a vehicle lamp as an example.

### (First Embodiment)

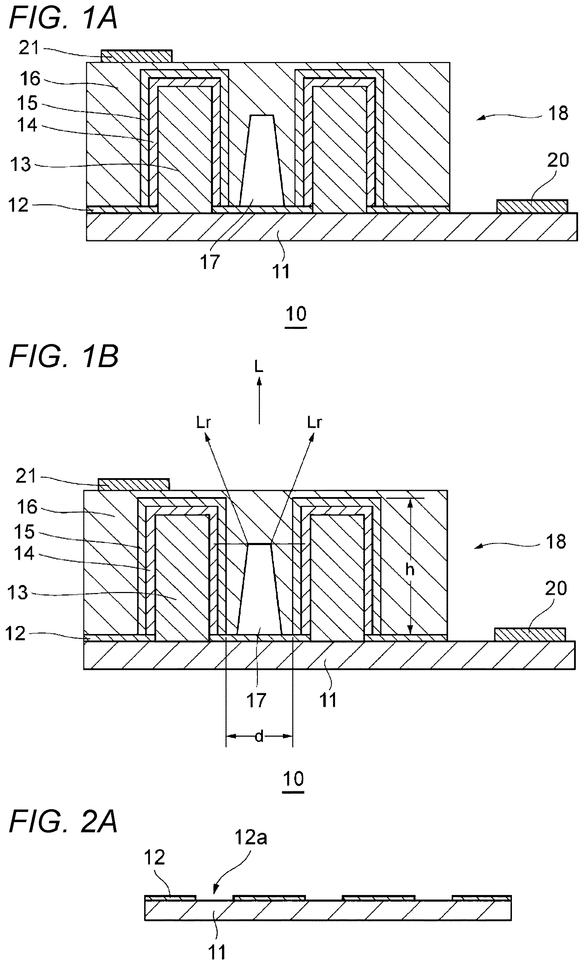

A semiconductor light-emitting element 10 according to a first embodiment will be described with reference to FIGS. 1A to 4. FIG. 1A is a cross-sectional view of the semiconductor light-emitting element 10 according to the first embodiment. As illustrated in FIG. 1A, the semiconductor light-emitting element 10 includes a growth substrate 11, a mask 12, nanowire layers 13, active layers 14, p-type semiconductor layers 15, an embedded layer 16, voids 17 (gaps), a mesa groove 18, a cathode electrode 20, and an anode electrode 21. Here, the nanowire layer 13, the active layer 14, and the p-type semiconductor layer 15 are selectively grown in a direction perpendicular to the growth substrate 11 and form a columnar shape, and constitute a columnar semiconductor layer in the present embodiment.

As illustrated in FIG. 1A, in a part of the semiconductor light-emitting element 10, the embedded layer 16 is removed from a surface thereof to the growth substrate 11 to form the mesa groove 18 (mesa structure), and a surface of the growth substrate 11 is exposed and the cathode electrode 20 is formed. The anode electrode 21 is formed on the embedded layer 16. Here, the mesa structure refers to a structure in which a groove penetrating semiconductor layers is formed to surround a predetermined region such that a cross section of a stacked structure of the semiconductor layers is exposed from a side surface.

The growth substrate 11 is a substantially flat plate-shaped member formed of a material supporting crystal growth of a semiconductor material, and the mask 12 is formed on a main surface side. A part of the growth substrate 11 is exposed and is formed with the cathode electrode 20. In a case in which the semiconductor light-emitting element 10 is formed of a nitride-based semiconductor, a GaN substrate is preferably used as the growth substrate 11, and for laser oscillation, a c-plane GaN substrate, on which a resonator plane is easy to be formed by cleavage, may be used. Alternatively, a different substrate such as a c-plane sapphire substrate or a Si substrate that is formed of a material different from the semiconductor material grown as the growth substrate 11 may be used to grow a plurality of semiconductor layers such as a buffer layer and an underlying layer.

The buffer layer is a layer formed between a single crystal substrate and the underlying layer to reduce lattice mismatch in between. In a case in which a c-plane sapphire substrate is used as the single crystal substrate, GaN is preferably used for the buffer layer, and AIN, AlGaN, and the like may also be used.

The underlying layer is a single crystal semiconductor layer formed on the growth substrate 11 or the buffer layer, and is preferably constituted by a plurality of layers including an n-type semiconductor layer such as an n-type contact layer provided on undoped GaN having a thickness of several µm. The n-type contact layer is a semiconductor layer doped with n-type impurities, and examples thereof include Si-doped n-type Al_{0.05}Ga_{0.95}N.

The mask 12 is a layer including a dielectric material formed on a surface of the growth substrate 11 or the underlying layer. A material that is difficult to grow a crystal of a semiconductor from the mask 12 is selected as a material forming the mask 12, and examples thereof include SiO₂, SiNx, and Al₂O₃. The mask 12 is formed with a plurality of openings to be described later, such that semiconductor layers can be grown from a part of the surface of the growth substrate 11 or the underlying layer exposed from the openings.

The nanowire layer 13 is a columnar semiconductor layer that is selectively grown (crystal-grown) on the growth substrate 11 or the underlying layer exposed from the opening 12a (see FIG. 2A) of the mask 12, and a substantially columnar semiconductor layer is formed vertically to a main surface of the growth substrate 11. Such a nanowire layer 13 can be obtained by setting appropriate growth conditions according to a semiconductor material forming the same and by performing selective growth in which a crystal plane in a specific orientation grows. In the example illustrated in FIG. 1A, the plurality of openings 12a are two-dimensionally and periodically formed in the mask 12, and thus the nanowire layers 13 are also two-dimensionally and periodically formed on the growth substrate 11.

The nanowire layer 13 is formed of, for example, GaN doped with n-type impurities. In a case in which GaN is used as the nanowire layer 13, the nanowire layer 13 selectively grown on the growth substrate 11 has a substantially hexagonal columnar shape in which six m-planes are formed as facets. In FIG. 1A, it appears that the nanowire layers 13 are grown only in regions at which the openings 12a are formed. However, in practice, the crystal growth also progresses on the mask 12 by lateral growth, and thus an enlarged hexagonal column is formed around the opening 12a. For example, in a case in which the openings 12a are each formed as a circle having a diameter of substantially 150 nm, it is possible to form the nanowire layer 13 having a hexagonal columnar shape and a height of substantially 1.0 µm to 2.0 µm with a hexagonal shape, as a bottom surface, inscribed in a circle having a diameter of substantially 200 nm. However, a size of the nanowire layer 13 is not limited thereto, and may be, for example, about 0.2 µm to 1.0 µm in width and about 0.5 µm to 2.5 µm in height. In addition, an interval (distance) between the nanowire layers 13 may be approximately 0.2 µm to 1.8 µm.

Although GaN is used as the nanowire layer 13 in the present embodiment, GaInN may be used as the nanowire layer 13 in order to reduce misfit dislocations due to lattice mismatch, in a case in which an In composition of the active layer 14 is increased in order to increase an emission wavelength. Similarly, in a case in which a wavelength of the semiconductor light-emitting element 10 is to be shortened, AlGaN can also be used as the nanowire layer 13, or a well layer and a barrier layer of the active layer 14 can also be changed to AlGaN having different compositions.

The active layer 14 is a semiconductor layer grown along the nanowire layer 13 on an outer periphery side of the nanowire layer 13, and is, for example, a multiple quantum well active layer in which a GaInN quantum well layer having a thickness of 5 nm and a GaN barrier layer having a thickness of 10 nm are stacked five times. Here, the multiple quantum well active layer is exemplified, and the active layer 14 may be a single quantum well structure or a bulk active layer. The active layer 14 is formed on side surfaces and an upper surface of the nanowire layer 13, and thus an area of the active layer 14 can be ensured. As a ratio of In adsorbed into the active layer 14 increases, the emission wavelength of the semiconductor light-emitting element 10 becomes longer, and the emission wavelength can be 480 nm or more in a case in which an In composition ratio is 0.10 or more. In a case in which the In composition ratio is 0.12 or more, the emission wavelength can be 500 nm or more. Since the side surfaces of the nanowire layer 13 are the m-planes, the active layer 14 formed on the side surfaces is also a nonpolar plane having the m-plane, such that droop characteristics can be improved.

The p-type semiconductor layer 15 is a semiconductor layer grown along the active layer 14 on the outer periphery side of the active layer 14, and is formed of, for example, GaN doped with p-type impurities. The p-type semiconductor layer 15 is formed on side surfaces and an upper surface of the active layer 14, and thus the n-type nanowire layer 13, the active layer 14, and the p-type semiconductor layer 15 form a double heterostructure, such that carriers are favorably confined in the active layer 14 and a probability of radiative recombination can be improved.

The embedded layer 16 is a semiconductor layer grown outside the p-type semiconductor layer 15, and is formed of GaN in the present embodiment. The embedded layer 16 covers side surfaces and an upper surface of the p-type semiconductor layer 15, and covers up to the growth substrate 11 or the underlying layer. Although FIG. 1A illustrates an example in which the embedded layer 16 includes a single layer, a stacked structure of a plurality of layers may be used as long as the semiconductor layer is embedded from the surface of the growth substrate 11 to an upper surface of the columnar semiconductor layer. The embedded layer 16 also has a function of fixing and protecting the thin nanowire layers 13. As will be described later, various materials may be used as a material of the embedded layer 16. A material having a band gap smaller than a band gap of a material forming the active layer 14 absorbs light emitted from the active layer 14, and thus it is necessary to select a material having a band gap larger than the band gap of the material forming the active layer 14.

The mesa groove 18 is a groove penetrating each of the semiconductor layers from an upper surface of the embedded layer 16 up to the growth substrate 11 or up to the underlying layer, and divides a light-emitting region of the semiconductor light-emitting element 10 to form a mesa structure. An outer periphery of the embedded layer 16 is exposed from a side surface of the mesa structure. Here, the exposure of the embedded layer 16 at the side surface of the mesa structure means that the outer periphery of the embedded layer 16 extends to the side surface of the mesa structure in a case in which the mesa groove 18 is formed, which includes forming a passivation film and other structures in the mesa groove 18 in a post-processing. The mesa groove 18 is further formed with an element isolation groove to separate the semiconductor light-emitting element 10 individually.

The cathode electrode 20 is an electrode formed in a region in which the growth substrate 11 or the underlying layer is exposed, and is constituted by a stacked structure of a metal material and a pad electrode, which is in ohmic contact with the exposed semiconductor layer. The anode electrode 21 is an electrode formed on a part of the embedded layer 16, and is constituted by a stacked structure of a metal material and a pad electrode, which is in ohmic contact with the outermost surface of the embedded layer 16. Although not illustrated in FIG. 1A, a known structure such as covering the surface of the semiconductor light-emitting element 10 with a passivation film may be applied as necessary. Alternatively, a transparent electrode obtained by extending the anode electrode 21 on the entire embedded layer 16 may be provided.

The voids 17 are gaps intentionally formed inside the embedded layer 16, and form an optical path conversion technique according to the present embodiment. The air is enclosed in the voids 17 as an example, but the present disclosure is not limited thereto, and another gas, for example, an inert gas such as nitrogen may be sealed. A size of the void is, for example, about 0.05 µm to 0.4 µm in width and about 0.3 µm to 0.7 µm in height.

The void 17 according to the present embodiment is formed by controlling an aspect ratio h/d of a space implemented by spaces between a plurality of columnar semiconductor layers, that is, (a height h of the columnar semiconductor layers)/(an interval d between the columnar semiconductor layers) defined using the height h of the columnar semiconductor layer and the interval d between the columnar semiconductor layers illustrated in FIG. 1B. In general, in a case in which an aperture provided in a substrate is filled with a predetermined substance by using sputtering or the like, when an aspect ratio of the aperture is large, the substance accumulates in the vicinity of an entrance of the aperture at a stage of sputtering to a certain degree, and a gap may be generated in a bottom portion of the aperture finally as the entrance is narrowed. In the semiconductor light-emitting element 10 according to the present embodiment, the voids 17 are intentionally formed inside the embedded layer 16 by using this phenomenon.

An operation of the void 17 of the semiconductor light-emitting element 10 according to the present embodiment will be described with reference to FIG. 1B. As described above, the semiconductor light-emitting element 10 is intended to extract light emitted from the active layer 14 as emitted light L from the upper surface. That is, most of the light emitted from the active layer 14 travels in a direction (hereinafter, may be referred to as a "lateral direction") parallel to the growth substrate 11. On the other hand, an interface between the voids 17 and the embedded layer 16 is a mirror surface or a rough surface, and the light traveling from the active layer 14 to the voids 17 through the embedded layer 16 is reflected or scattered. Therefore, in the semiconductor light-emitting element 10, the light traveling in the lateral direction from the active layer 14 is reflected or scattered by the voids 17, whereby an optical path is converted to an upper surface direction. For example, a reflected light in the voids 17 will be described. As illustrated in FIG. 1B, the light traveling in the lateral direction from the active layer 14 is reflected by the voids 17 and travels toward the upper surface direction as reflected light Lr. That is, the voids 17 function as an optical path conversion unit that converts the optical path in the lateral direction of the light generated in the active layer 14 into an optical path in the upper surface direction. At this time, as a refractive index of the material of the embedded layer 16 is larger, a refractive index difference between the material of the embedded layer 16 and the inside of the voids 17 becomes larger, and a critical angle becomes narrower, and thus a reflection effect is enhanced. According to the above-described operation, the semiconductor light-emitting element 10 can increase an amount of light emitted from the upper surface with a simple configuration.

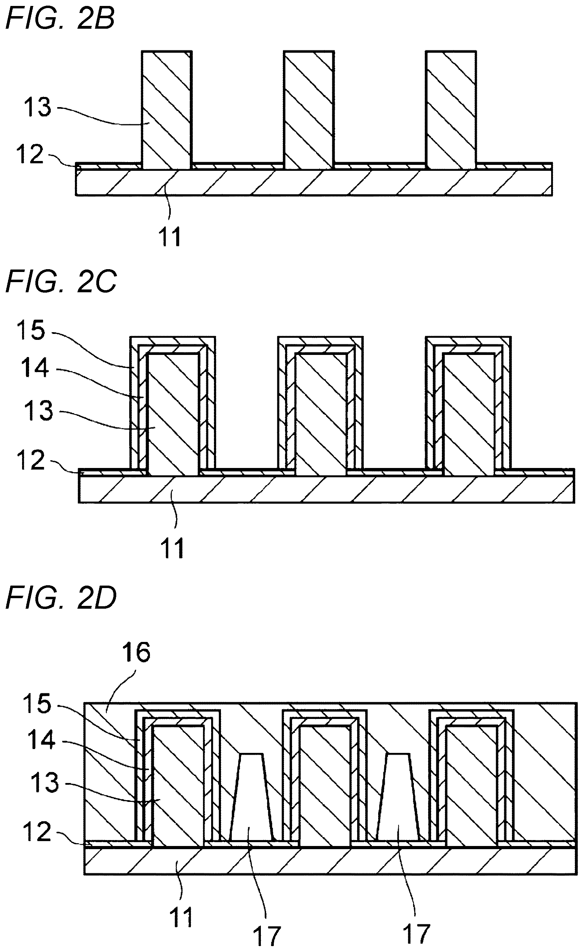

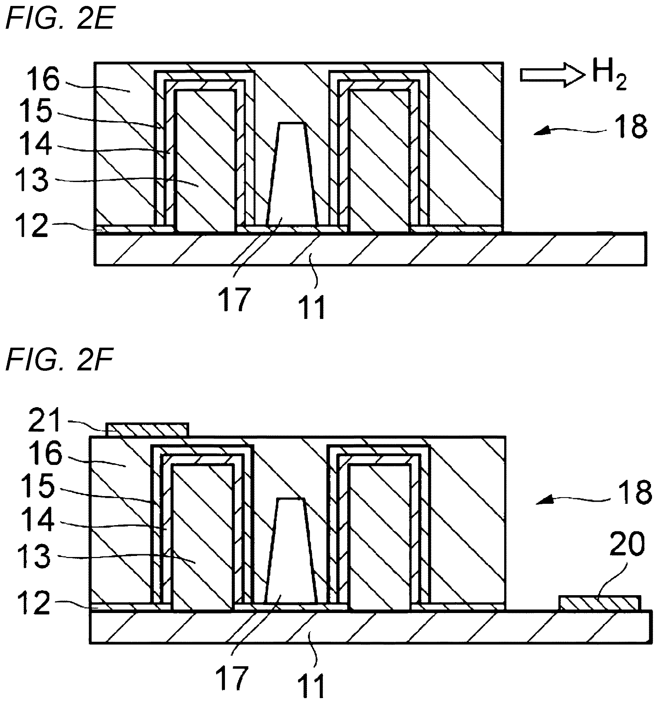

FIGS. 2A to 2F are cross-sectional views illustrating a method for manufacturing the semiconductor light-emitting element 10, in which FIG. 2A illustrates a mask forming step, FIG. 2B illustrates a nanowire growing step, FIG. 2C illustrates a growing step of an active layer and a p-type semiconductor layer, FIG. 2D illustrates a void forming step, FIG. 2E illustrates a groove etching step and an activation step, and FIG. 2F illustrates an electrode forming step.

First, in the mask forming step illustrated in FIG. 2A, the mask 12 formed of SiO₂ is deposited on the growth substrate 11 formed of n-type GaN to have a film thickness of substantially 30 nm by using a sputtering method, and the openings 12a each having a diameter of substantially 150 nm are formed by using a fine pattern forming method such as nano-imprinting lithography. In a case in which a different substrate such as sapphire substrate is used as the growth substrate 11, a buffer layer, an underlying layer, and an n-type semiconductor layer may be formed on the sapphire substrate, and a surface of the n-type semiconductor layer may be used as the surface of the growth substrate 11. Growth conditions of the buffer layer are, for example: trimethylalminium (TMA), trimethylgallium (TMG), and ammonia are used as source gases; a growth temperature is 1100°C; a V/III ratio is 1000; and a pressure is 10 hPa using hydrogen as a carrier gas. Growth conditions of the underlying layer and the n-type semiconductor layer are, for example: a growth temperature is 1050°C; a V/III ratio is 1000; and a pressure is 500 hPa using hydrogen as a carrier gas.

Next, in the nanowire growing step illustrated in FIG. 2B, the nanowire layer 13 formed of GaN is grown, by selective growth using an MOCVD method, on the growth substrate 11 exposed from the opening 12a. Growth conditions of the nanowire layer 13 are, for example: TMG and ammonia are used as source gases; a growth temperature is 1050°C; a V/III ratio is 10; and a pressure is 100 hPa using hydrogen as a carrier gas.

Next, in the growing step of the active layer and the p-type semiconductor layer illustrated in FIG. 2C, first, the active layer 14, in which a GaInN quantum well layer having a thickness of 5 nm and a GaN barrier layer having a thickness of 10 nm are stacked five times, is grown on the side surfaces and the upper surface of the nanowire layer 13 by using the MOCVD method. Growth conditions of the active layer 14 are, for example: a growth temperature is 800°C; a V/III ratio is 3000; nitrogen is used as a carrier gas; a pressure is 1000 hPa; and TMG, trimethylindium (TMI), and ammonia are used as source gases.

Thereafter, the p-type semiconductor layer 15 formed of GaN doped with p-type impurities is grown. Growth conditions of the p-type semiconductor layer 15 are, for example: a growth temperature is 950°C; a V/III ratio is 1000; hydrogen is used as a carrier gas; a pressure is 300 hPa; and TMG, bis(cycropentadienyl)magnesium (Cp₂Mg), and ammonia are used as source gases.

Next, in the void forming step illustrated in FIG. 2D, the embedded layer 16 formed of GaN is grown, and an outer periphery and the upper surface of the columnar semiconductor layer constituted by the nanowire layer 13, the active layer 14, and the p-type semiconductor layer 15 are filled with the embedded layer 16. Growth conditions of the embedded layer 16 are, for example: a growth temperature is 950°C; a V/III ratio is 1000; hydrogen is used as a carrier gas; a pressure is 300 hPa; and TMG, bis(cycropentadienyl)magnesium (Cp₂Mg), and ammonia are used as source gases. To increase a thickness of the embedded layer 16, the growth conditions of the embedded layer 16 are preferably conditions under which c-plane growth, which is growth in a vertical direction, is promoted.

The embedded layer 16 is grown on the mask 12 provided between the columnar semiconductor layers, but in the present embodiment, as described above, voids (gaps) are intentionally generated in the lower portion of the columnar semiconductor layer by controlling the aspect ratio = (the height of the columnar semiconductor layers)/(the interval between the columnar semiconductor layers). This is because when the aspect ratio of the columnar semiconductor layers is high, a raw material is easy to grow a crystal in an upper portion of the columnar semiconductor layer during the growth of the embedded layer 16, and an amount of the raw material reaching the vicinity of a root close to the growth substrate 11 decreases.

As described above, the height of the nanowire layers 13 is about 0.5 µm to 2.5 µm, and the interval between the nanowire layers 13 is about 0.2 µm to 1.8 µm. Therefore, in consideration of the size, in the present embodiment, the aspect ratio = (the height of the columnar semiconductor layers)/(the interval between the columnar semiconductor layers) is set to be in a range of 0.5 or more, and more preferably in a range of 3 to 5.

A more detailed example of the growth conditions of the embedded layer 16 is as follows. That is, in the growth of the embedded layer 16, the embedded layer 16 preferably grows using TMG, silane, and ammonia as source gases at a low temperature and a low V/III ratio in which m-plane growth, which is lateral growth, is promoted in an initial stage. Examples of the low temperature and low V/III ratio include a V/III ratio of 100 or less at 800°C or less and a pressure of 200 hPa using hydrogen as a carrier gas. After the lower portions of the columnar semiconductor layers are filled with regions other than the voids 17 on the mask 12 by the lateral growth of the embedded layer 16, the growth is preferably performed at a high temperature and a high V/III ratio that promotes the c-plane growth, which is vertical growth. Examples of the high temperature and the high V/III ratio include a V/III ratio of 2000 or more at 1000°C or more, and a pressure of 500 hPa using hydrogen as a carrier gas.

In the present embodiment, the voids are generated by basically controlling the aspect ratio = (the height of the columnar semiconductor layers)/(the interval between the columnar semiconductor layers), but the growth conditions of the embedded layer 16 may be appropriately changed such that the voids are easily generated.

Next, in the groove etching step and the activation step illustrated in FIG. 2E, the mesa groove 18 reaching the growth substrate 11 from the upper surface of the embedded layer 16 is selectively formed by dry etching. After the mesa groove portion 18 is formed, an activation step is performed, and an activation treatment is performed in which hydrogen is released from the embedded layer 16 that reaches up to the side surface of the mesa structure and is exposed. Here, a method for the activation treatment is not limited, and a heat treatment (annealing) at 600°C in the air atmosphere is exemplified as an example. Although annealing in the air atmosphere is shown, the heat treatment in an atmosphere in which no atomic hydrogen is present and the embedded layer 16 can be activated may be performed.

Next, in the electrode forming step illustrated in FIG. 2F, the cathode electrode 20 is formed on the surface of the growth substrate 11, and the anode electrode 21 is formed on the embedded layer 16. As necessary, annealing, forming of a passivation film, and element division are performed after the forming of the electrodes to obtain the semiconductor light-emitting element 10.

In the semiconductor light-emitting element 10 according to the present embodiment, in a case in which a voltage is applied between the cathode electrode 20 and the anode electrode 21, a current flows through the embedded layer 16, the p-type semiconductor layer 15, the active layer 14, the nanowire layer 13, and the growth substrate 11 in this order, and light is generated in the active layer 14 due to radiative recombination. The light emitted from the active layer 14 is extracted to the outside of the semiconductor light-emitting element 10. At this time, in the semiconductor light-emitting element 10 according to the present embodiment, an amount of light extracted from an upper surface of the semiconductor light-emitting element 10 is increased by the operation of the voids 17 described above.

Since the side surfaces of the nanowire layer 13 are m-planes formed by selective growth, the active layer 14 formed on the outer periphery of the nanowire layer 13 and the p-type semiconductor layer 15 are also in contact with each other on the m-planes. Since the m-plane is a nonpolar plane and is not polarized, the active layer 14 has a high luminous efficiency. Since all side surfaces of a hexagonal column are m-planes, a luminous efficiency of the semiconductor light-emitting element 10 can be improved. Further, a film thickness of the active layer 14 can be increased, and thus a volume of the active layer 14 can be increased to substantially 3 to 10 times as large as that of a semiconductor light-emitting element in the related art, and an injected carrier density can be reduced to significantly reduce an efficiency droop.

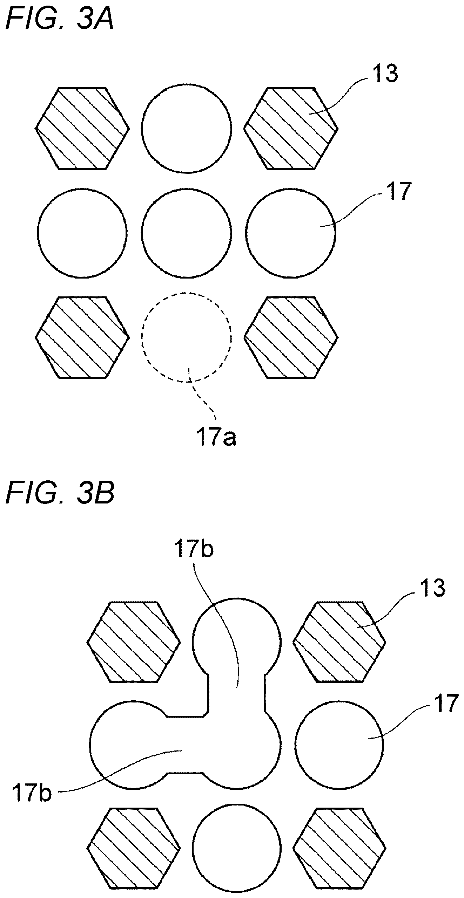

Next, the voids 17 according to the present embodiment will be described in more detail with reference to FIGS. 3A and 3B. FIGS. 3A and 3B are diagrams illustrating a shape of the voids 17 formed in the semiconductor light-emitting element 10 in a plan view. As described above, as illustrated in FIG. 3A, there is a possibility that the voids 17 according to the present embodiment are formed at five positions between the columnar semiconductor layers (the nanowire layers 13 are illustrated in FIGS. 3A and 3B) and the columnar semiconductor layers arranged at vertexes of a rectangle as an example. However, it is not necessary that the voids 17 are formed at all the five positions illustrated in FIG. 3A, and there may be a portion at which no void 17 is formed as illustrated in a non-defective portion 17a.

As illustrated in FIG. 3B, the voids 17 according to the present embodiment may be gaps in which the void 17 and the void 17 are connected and integrated by connection portions 17b.

The arrangement of the columnar semiconductor layers is not limited to the vertexes of the rectangle as in the present embodiment, and may be vertexes of other polygons such as vertexes of a triangle. In this case, the voids 17 may also be formed between the columnar semiconductor layers.

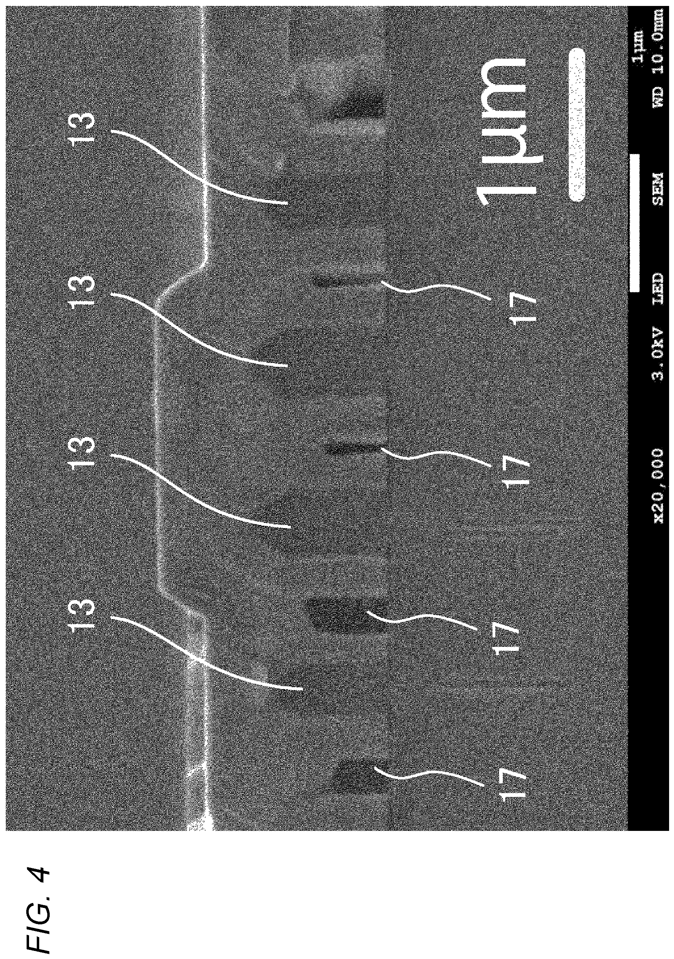

FIG. 4 illustrates a photograph of the voids 17, which is taken by a scanning electron microscope (SEM), the voids 17 being actually generated in the semiconductor light-emitting element 10 according to the present embodiment. As illustrated in FIG. 4, it can be seen that the voids 17 are generated between the nanowire layers 13.

### (Second Embodiment)

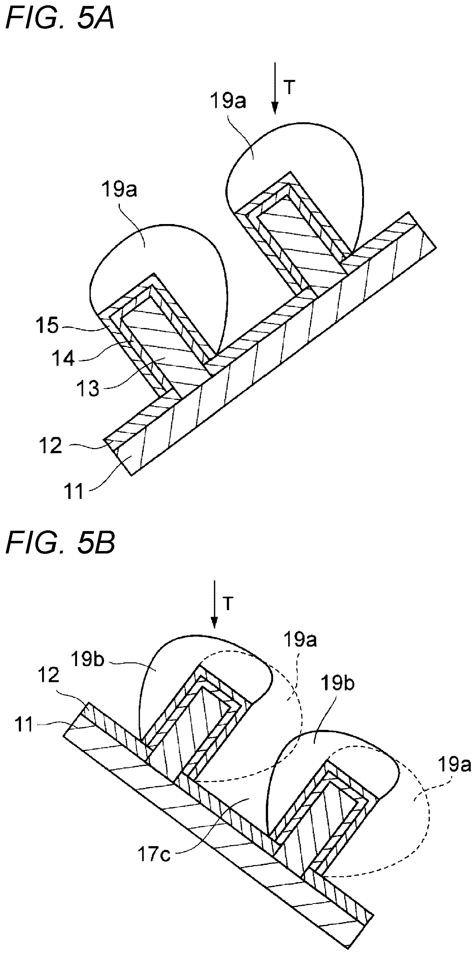

A second embodiment will be described with reference to FIGS. 5A to 5C. The present embodiment is an aspect in which the embedded layer 16 in the semiconductor light-emitting element 10 according to Embodiment 1 is replaced with an indium tin oxide (ITO) film. Therefore, the configuration of the semiconductor light-emitting element is common to FIGS. 1A to 2F except for the embedded layer 16, and FIGS. 1A to 2F are referred to as necessary, and the illustration of the semiconductor light-emitting element is omitted. In addition, the same components as those of Embodiment 1 are denoted by the same reference numerals, and detailed description thereof is omitted.

A main function of the embedded layer 16 of the semiconductor light-emitting element 10 is to form a current path toward the p-type semiconductor layer 15, and the ITO film used for a transparent electrode or the like can be used as a substitute for the embedded layer 16. The ITO film may be formed by using the sputtering method. For example, a film may be formed by using an RF magnetron sputtering apparatus, which uses an ITO as a target, to cause the ITO to fly and to deposit the ITO on a target region.

FIGS. 5A to 5C are diagrams illustrating a void forming step according to the present embodiment, which corresponds to the void forming step illustrated in FIG. 2D. In the present embodiment, a relative angle between a target T formed of an ITO and the growth substrate 11 is changed, and the film is formed in a plurality of times. FIGS. 5A to 5C exemplify an aspect in which an angle of the growth substrate 11 is changed with respect to the target T flying in a vertical direction, and may exemplify an aspect in which the growth substrate 11 is horizontal and an angle of a flying direction of the target T is shifted from vertical.

As illustrated in FIG. 5A, the growth substrate 11 is tilted at a predetermined angle to perform a first film formation. Since the flying direction of the target T and the main surface of the growth substrate 11 are not perpendicular to each other, an ITO film 19a is deposited unevenly with respect to the columnar semiconductor layer. That is, the ITO film 19a is mainly deposited on a specific surface of the columnar semiconductor layer.

Next, as illustrated in FIG. 5B, the growth substrate 11 is tilted in a direction different from that of FIG. 5A to perform a second film formation. A tilt angle may be the same as or different from that during the first film formation. An ITO film 19b is deposited on a surface of the columnar semiconductor layer different from that of FIG. 5A. A gap 17c is formed by overlapping the ITO film 19a and the ITO film 19b between the columnar semiconductor layers. The gap 17c is a gap in the ITO film formed on the mask 12.

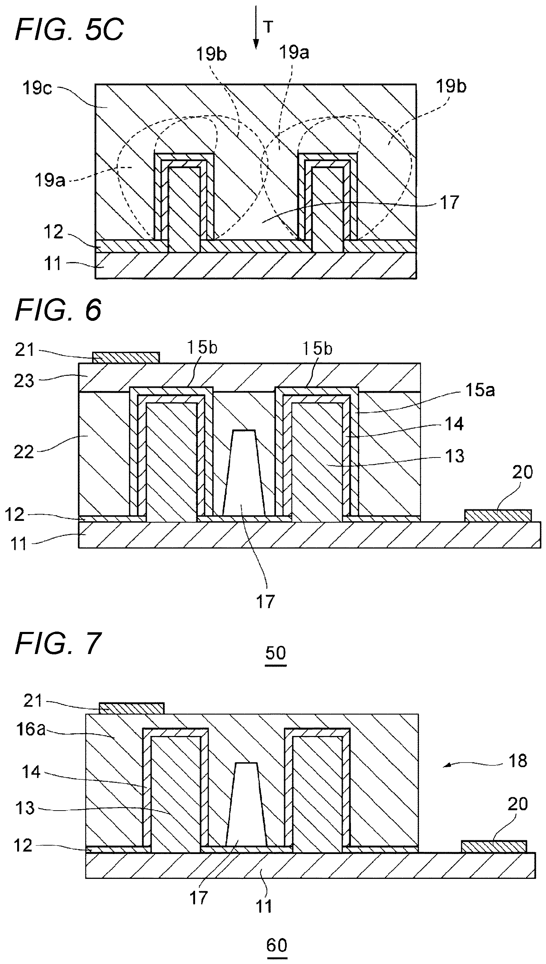

Next, as illustrated in FIG. 5C, the growth substrate 11 is set horizontally, and a third film formation is performed with an angle formed between the target T and the main surface of the growth substrate 11 being perpendicular. Through the film formation, an ITO film 19c with which the ITO films 19a and 19b are filled is formed. A shape of the gap 19c is determined through the film formation, and the void 17 is finally formed.

In the present embodiment, an aspect is described in which the number of times of film formation by sputtering performed by changing the relative angle between the target T and the growth substrate 11 is set to two, and the number of times is not limited to two, and may be three or more, or one in consideration of the above-described aspect ratio. A shape of the columnar semiconductor layer of the semiconductor light-emitting element according to the present embodiment in a plan view is a hexagonal shape, and thus when the number of times of film formation is three or six, the voids 17 each having a more uniform shape are formed.

As described above, the semiconductor light-emitting element according to the present embodiment can increase an amount of light emitted from the upper surface with a simple configuration.

### (Third Embodiment)

A semiconductor light-emitting element 50 according to a third embodiment will be described with reference to FIG. 6. In the present embodiment, the embedded layer 16 in the first embodiment is replaced with an insulator. Therefore, the same components as those of the first embodiment are denoted by the same reference numerals, and detailed description thereof is omitted.

In the semiconductor light-emitting element 50 according to the present embodiment, by separately providing a current path from the anode electrode 21 to the p-type semiconductor layer 15, a dielectric such as SiO₂ may be used instead of the embedded layer 16. Alternatively, a transparent resin such as a silicone resin may be used to form the embedded layer 16 as an insulator layer transparent to the light generated from the active layer 14. However, the material of the embedded layer used in the present embodiment is not limited thereto, and another insulator transparent to the light emitted from the active layer 14 may be used.

FIG. 6 illustrates the semiconductor light-emitting element 50 using an SiO₂ layer 22 as the embedded layer. As illustrated in FIG. 6, the semiconductor light-emitting element 50 includes p-type semiconductor layers 15a, an SiO₂ layer 22, and an ITO film 23.

The p-type semiconductor layer 15a includes a contact layer 15b, which is in ohmic contact with an electrode material in an upper surface-side region of the p-type semiconductor layer 15, and is formed such that a part of the upper surface side protrudes from the SiO₂ layer 22. The contact layer 15b may be formed not only on an upper surface-side region of the p-type semiconductor layer 15a but also on an entire outer surface of the p-type semiconductor layer 15a.

A film of the SiO₂ layer 22 is formed around the columnar semiconductor layers by using, for example, a chemical vapor deposition (CVD) method, and mainly has a function of protecting the columnar semiconductor layers. In the present embodiment, the voids 17 are formed by setting the aspect ratio in the film formation process of the SiO₂ layer 22.

When the SiO₂ layer is formed by using the sputtering method, as in the second embodiment, the film may be formed by performing sputtering a plurality of times while shifting an angle formed by a direction of the target and the main surface of the growth substrate 11 from perpendicular.

The ITO film 23 is formed on the SiO₂ layer 22 so as to be in contact with the contact layers 15b of the p-type semiconductor layer 15a, and the anode electrode 21 is disposed on the ITO film 23. The ITO film 23 is an example of a transparent electrode, and another transparent electrode material may be used.

In the semiconductor light-emitting element according to the present embodiment, a current flows through the anode electrode 21, the ITO film 23, the contact layer 15b of the p-type semiconductor layer 15a, the p-type semiconductor layer 15a, the active layer 14, the nanowire layer 13, and the growth substrate 11 in this order, and light is emitted in the active layer 14. A part of the light generated in the active layer 14 is converted into an optical path in the upper surface direction by the void 17.

The semiconductor light-emitting element 50 described above can increase an amount of light emitted from the upper surface with a simple configuration.

Here, in the semiconductor light-emitting element of the present embodiment, the SiO₂ layer 22 may be replaced with a silicone resin. In this case, a film of the silicone resin may be formed by using a spin coating method. In the film formation of the silicone resin using the spin coating method, the generation of the voids 17 may be controlled by controlling a rotation speed of the growth substrate 11, a supply speed of the silicone resin, and the like in addition to the control of the aspect ratio.

### (Fourth Embodiment)

A semiconductor light-emitting element 60 according to a fourth embodiment will be described with reference to FIG. 7. In the present embodiment, the embedded layer 16 in the first embodiment is replaced with a p-type semiconductor layer 16a. In the above-described embodiments, the aspect has been described as an example in which the semiconductor light-emitting element includes the p-type semiconductor layer 15 formed along the active layer 14 outside the active layer 14, and the embedded layer 16 formed on the mask 12 so as to be in contact with the p-type semiconductor layer 15. However, the semiconductor light-emitting element 60 can also be constituted by the nanowire layers 13, the active layers 14 each formed along the nanowire layer 13 outside the nanowire layer 13, and the p-type semiconductor layer 16a formed on the mask 12 so as to be in contact with the active layers 14. The p-type semiconductor layer 16a is formed of, for example, p-type GaN. In this case, the anode electrode 21 is disposed on an upper surface of the p-type semiconductor layer 16a. In the present embodiment, the columnar semiconductor layer is constituted by the nanowire layer 13 and the active layer 14.

In the semiconductor light-emitting element 60 according to the present embodiment, the void 17 is formed between the columnar semiconductor layers in the p-type semiconductor layer 16a. In the manufacturing method (in particular, a method for forming the void 17) according to the present embodiment, the aspect ratio is controlled in the same manner as in the first embodiment in which the embedded layer 16 is formed of GaN.

In the semiconductor light-emitting element 60 according to the present embodiment, a current flows through the anode electrode 21, the p-type semiconductor layer 16a (embedded layer), the active layer 14, the nanowire layer 13, and the growth substrate 11 in this order, and light is emitted in the active layer 14. A part of the light generated in the active layer 14 is converted into an optical path in the upper surface direction by the void 17.

As described above, the semiconductor light-emitting element according to the present embodiment can increase an amount of light emitted from the upper surface with a simple configuration.

The present disclosure is not limited to the embodiments described above, and various modifications can be made within the scope of the claims. Embodiments obtained by appropriately combining technical techniques disclosed in different embodiments are also included in the technical scope of the present disclosure.

The present disclosure is based on Japanese Patent Application No. 2021-113881 filed on July 8, 2021, and contents thereof are incorporated herein by reference.

### INDUSTRIAL APPLICABILITY

According to the present disclosure, it is possible to provide a semiconductor light-emitting element, a vehicle lamp, and a method for manufacturing a semiconductor light-emitting element that can increase an amount of light emitted from an upper surface with a simple configuration.

## Claims

1. A semiconductor light-emitting element comprising:
a growth substrate;
a plurality of columnar semiconductor layers on the growth substrate; and
an embedded layer with which the plurality of columnar semiconductor layers are covered,
wherein each of the plurality of columnar semiconductor layers comprises:
an n-type nanowire layer at a center of each of the columnar semiconductor layers; and
an active layer on an outer periphery side of the n-type nanowire layer,
and
wherein the embedded layer defines a gap above the growth substrate between the columnar semiconductor layer and the columnar semiconductor layer.

2. The semiconductor light-emitting element according to claim 1,
wherein the growth substrate is a GaN substrate, and
wherein the embedded layer is a GaN layer.

3. The semiconductor light-emitting element according to claim 1,
wherein the embedded layer is an ITO film.

4. The semiconductor light-emitting element according to claim 1,
wherein each of the plurality of columnar semiconductors further comprises a p-type semiconductor layer on an outer periphery side of the active layer.

5. The semiconductor light-emitting element according to claim 4,
wherein the p-type semiconductor layer comprises a contact layer at least on an upper surface thereof,
wherein the embedded layer is an insulator layer transparent to light generated from the active layer,
wherein the semiconductor light-emitting element further comprises a transparent electrode disposed on the insulator layer, and
wherein the contact layer protrudes from the insulator layer and is in contact with the transparent electrode.

6. The semiconductor light-emitting element according to any one of claims 1 to 5,
wherein an aspect ratio defined by a height of the columnar semiconductor layers and an interval between the columnar semiconductor layers is 0.5 or more, and more preferably 3 to 5.

7. A vehicle lamp using the semiconductor light-emitting element according to any one of claims 1 to 6.

8. A method for manufacturing a semiconductor light-emitting element, the method comprising:
a masking step of forming a mask layer having a plurality of openings on a growth substrate, the mask layer having a plurality of openings;
a growing step of forming a plurality of columnar semiconductor layers in the respective plurality of openings using selective growth; and
an embedding step of growing an embedded layer on the growth substrate so as to cover the plurality of columnar semiconductor layers,
wherein the growing step comprises:
a step of forming an n-type nanowire layer;
a step of forming an active layer outside the n-type nanowire layer; and
a step of forming a p-type semiconductor layer outside the active layer,
and
wherein the embedding step comprises a step of forming a gap on the mask layer between the columnar semiconductor layers inside the embedded layer.

9. The method for manufacturing a semiconductor light-emitting element according to claim 8,
wherein an aspect ratio defined by a height of the columnar semiconductor layers and an interval between the columnar semiconductor layers is set to 0.5 or more, and more preferably 3 to 5.
